(19) Europäisches Patentamt
European Patent Office
Office européen des brevets

(11) **EP 2 844 046 B1**

(12) **EUROPÄISCHE PATENTSCHRIFT**

(45) Veröffentlichungstag und Bekanntmachung des Hinweises auf die Patenterteilung:
**05.04.2017 Patentblatt 2017/14**

(21) Anmeldenummer: **14182517.4**

(22) Anmeldetag: **27.08.2014**

(51) Int Cl.:
*H05K 5/02* *(2006.01)*     *H02B 1/28* *(2006.01)*

(54) **Gehäuseteil für ein explosionsgeschütztes Gehäuse mit einem porösen Körper**

Housing part for a housing with flameproof encapsulation comprising a porous body

Partie de boîtier pour un boîtier anti-déflagrant doté d'un corps poreux

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.08.2013 DE 102013109260**

(43) Veröffentlichungstag der Anmeldung:
**04.03.2015 Patentblatt 2015/10**

(73) Patentinhaber: **R. Stahl Schaltgeräte GmbH 74638 Waldenburg (DE)**

(72) Erfinder:
• **Mann, Ulrich**
  **74523 Schwäbisch Hall (DE)**
• **Limbacher, Bernd**
  **74523 Schwäbisch Hall (DE)**

(74) Vertreter: **Rüger, Barthelt & Abel Patentanwälte Webergasse 3 73728 Esslingen (DE)**

(56) Entgegenhaltungen:
**DE-A1-102008 024 844    DE-A1-102010 016 782**

## Beschreibung

Die Erfindung betrifft ein Gehäuseteil für ein explosionsgeschütztes Gehäuse. Als Gehäuseteil kann beispielsweise eine Gehäusewand, ein Gehäusewandabschnitt oder ein mit einer Gehäusewand verbindbarer Stutzen dienen. Das explosionsgeschützte Gehäuse ist vorzugsweise in der Zündschutzart "druckfeste Kapselung" (Ex-d) ausgeführt. In dem explosionsgeschütztes Gehäuse befinden sich üblicherweise elektrische und/oder elektronische Bauteile bzw. Komponenten, die Zündquellen für eine in der Umgebung außerhalb des Gehäuses vorhandene explosionsgefährdete Atmosphäre darstellen können. Das explosionsgeschützte Gehäuse trennt derartige Zündquellen von der explosionsgefährdeten Atmosphäre.

Das Gehäuse bzw. das Gehäuseteil mit dem porösen Körper stellt eine Durchströmvorrichtung dar, die eine Gasaustauschverbindung zwischen dem Inneren des Gehäuses und der Umgebung bereitstellt. Diese Verbindung kann dazu dienen, den sich z.B. aufgrund von Temperaturänderungen ergebenden Druckunterschied zwischen dem Innenraum des Gehäuses und der Umgebung auszugleichen. Zusätzlich oder alternativ wird durch die Gasaustauschverbindung durch den gasdurchlässigen porösen Körper sichergestellt, dass der Druck auf das Gehäuse im Falle einer innerhalb des Gehäuses stattfindenden Explosion begrenzt wird. Der poröse Körper stellt dabei eine gasdurchlässige Barriere dar, die Flammen und Zündfunken oder dergleichen nicht aus dem Innenraum des Gehäuses nach außen dringen lässt. Der poröse Körper ist mithin frei von Zündspalten und daher zünddurchschlagsicher ausgeführt. Da sich das Gasvolumen im Falle einer Explosion durch den porösen Körper nach außen in die Umgebung des Gehäuses ausdehnen kann, wird der Explosionsdruck auf das Gehäuse begrenzt, so dass dieses der Explosion standhält und keine Risse oder Spalten bildet, durch die Flammen oder Zündfunken aus dem Innenraum des Gehäuses nach außen gelangen könnten.

Ein Gehäuseteil mit einem porösen Körper zur Bildung einer Druckentlastungsvorrichtung ist aus US 4 180 177 A bekannt. Der poröse Körper ist in einen Durchgang in der Gehäusewand eingesetzt. Um das Eindringen von Wasser in das Gehäuse zu vermeiden, ist der poröse Körper durch eine Klappe abgedeckt. Diese Klappe öffnet, sobald im Inneren des Gehäuses ein ausreichend großer Überdrück auftritt. Nachteilig ist dabei, dass zunächst ein bestimmter Überdruck innerhalb des Gehäuses auftreten muss, damit die Klappe überhaupt öffnet. Kleinere Druckunterschiede können nicht kontinuierlich ausgeglichen werden. Die Funktionsfähigkeit der Klappe muss sichergestellt und gegebenenfalls regelmäßig geprüft werden.

DE 10 2010 016 782 A1 beschreibt eine Druckentlastungsvorrichtung mit einem Stutzen, der von einem Durchgang durchsetzt wird, in dem ein poröser Körper angeordnet ist. Der Durchgang im Stutzen kann außerdem von einer Membran vollständig abgedeckt sein, um das Eindringen von Wasser durch den porösen Körper in das Gehäuse zu vermeiden. Die Membran begrenzt aber den Volumen- bzw. Massenstrom durch den porösen Körper.

Die Verwendung einer luftdurchlässigen Membran bei einem Luftfilter ist in EP 2 404 652 A1 vorgeschlagen. Die dort beschriebene Konstruktion eignet sich allerdings nicht für explosionsgeschützte Anwendungen.

Ein Belüftungs- und Entwässerungsstutzen für ein Gehäuse ist aus DE 43 13 776 C1 bekannt. Dort ist eine Labyrinthanordnung vorhanden, durch die ein Luftaustausch ermöglicht wird. Durch die Labyrinthanordnung kann Wasser aus dem Inneren des Gehäuses abgeführt werden, jedoch ist das Eindringen von Wasser in den Innenraum des Gehäuses vermieden.

Ein Klimastutzen zur Schaffung eines Druckausgleichs zwischen dem Innenraum eines Gehäuses und der Umgebung und zur Verhinderung des Eindringens von Wasser in den Innenraum des Gehäuses ist aus DE 10 2008 024 844 A1 bekannt. Dort ist eine Topfmembran in einen Hohlzylinder eingesetzt. Die Topfmembran besteht aus einem porösen Material, beispielsweise aus Polypropylen, hochporöses Polystyrol oder Polytetrafluorethylen, welches durch seine symmetrische Porenstruktur einen hydrophobischen Charakter aufweist und für Temperaturen zwischen -40°C und +125°C geeignet ist.

US 3 987 258 beschreibt eine Spritzwasserschutzabdeckung für ein Radio. Allerdings ist auch bei diesem Stand der Technik ein Explosionsschutz nicht gewährleistet.

Ausgehend von dem beschriebenen Stand der Technik ist es eine Aufgabe der vorliegenden Erfindung ein Gehäuseteil für ein explosionsgeschütztes Gehäuse zu schaffen, das einen hohen Gasvolumenstrom sicherstellt und dennoch auf einfache Weise das Eindringen von Wasser in das Gehäuse vermeidet.

Diese Aufgabe wird durch ein Gehäuseteil für ein explosionsgeschütztes Gehäuse mit den Merkmalen des Patentanspruches 1 gelöst.

Erfindungsgemäß weist das Gehäuseteil eine Durchströmvorrichtung mit einem Durchgang auf, in den ein poröser Körper eingesetzt ist. Als Gehäuseteil kann beispielsweise eine Gehäusewand, ein Gehäusewandabschnitt oder ein Stutzen mit einem Durchgang dienen. Der poröse Körper ist in dem Durchgang kraftschlüssig und/oder stoffschlüssig und/oder formschlüssig angeordnet, ohne dass zwischen der den Durchgang begrenzenden Wand und dem porösen Körper ein Zündspalt verbleibt. Eine Innenseite des porösen Körpers ist dem Innenraum des Gehäuses zugeordnet. Die entgegengesetzte Außenseite des porösen Körpers ist der Umgebung des Gehäuses zugeordnet. Gas kann an der Innenseite in den porösen Körper eindringen und an der Außenseite des porösen Körpers ausströmen. Auch eine entgegengesetzte Gasströmung ist möglich.

Der poröse Körper weist eine hydrophobe Oberfläche auf. Die hydrophobe Oberfläche ist durch eine Beschichtung gebildet. Eine Oberflächenaktivierung kann beispielsweise durch Laserinterferenzstrukturierung oder Nanostrukturen erreicht werden. Die hydrophobe Oberfläche ist in wenigstens einem Bereich des porösen Körpers vorhanden. Sie verhindert, dass Wasser aus der Umgebung in den Innenraum des Gehäuses eindringen kann. Bei einem bevorzugten Ausführungsbeispiel kann eine Schicht oder Lage des porösen Körpers, die die Außenseite enthält, die hydrophobe Oberfläche aufweisen.

Durch die erfindungsgemäße Ausgestaltung kann eine wasserabweisende Membran am Durchgang entfallen. Dadurch ist der Gasvolumenstrom durch den porösen Körper ungehindert möglich. Die hydrophobe Oberfläche beeinträchtigt den Gasvolumenstrom nicht merklich. Somit kann auch bei kleineren Druckunterschieden ein Druckausgleich ungehindert stattfinden. Außerdem wird der Aufbau und die Montage des Gehäuseteils vereinfacht. Das Gehäuseteil kann auch im Falle einer Explosion im Inneren des Gehäuses als Druckentlastungsvorrichtung den Gehäusedruck begrenzen. Aufgrund der Druckentlastung kann das Gehäuse selbst weniger stabil ausgeführt werden, als ohne eine solche Druckentlastung. Auch im Falle eines plötzlichen Druckanstiegs während einer Explosion ist ein ungehindert großer Gasvolumenstrom durch den porösen Körper sichergestellt.

Die hydrophobe Oberfläche, die durch eine Beschichtung gebildet ist, ist insbesondere im Bereich der Außenseite des porösen Körpers vorhanden. Im Explosionsfall ist die Gastemperatur an der Außenseite geringer, so dass die hydrophobe Oberfläche durch die an der Innenseite in den porösen Körper einströmenden heißen Explosionsgase nicht oder weniger stark beeinträchtigt wird. Alternativ hierzu kann die hydrophobe Oberfläche auch im Bereich der Innenseite des porösen Körpers vorhanden sein oder sowohl auf der Innenseite, als auch auf der Außenseite. Es ist außerdem möglich, den gesamten porösen Körper mit einer hydrophoben Oberfläche auszubilden bzw. zu versehen. Es genügt bei allen Ausführungsbeispielen, wenn die hydrophobe Oberfläche im Oberflächenbereich des porösen Körpers vorhanden ist. Der innere Kern des porösen Körpers kann, muss aber keine hydrophobe Oberfläche aufweisen.

Die hydrophobe Oberfläche kann ein Fluorcarbon und/oder ein Silan enthalten. Ein Fluorcarbon und/oder Silan hat den Vorteil, dass es neben seiner hydrophoben Wirkung auch gegen das Eindringen von öligen Flüssigkeiten in den Innenraum des Gehäuses schützt. Außerdem wir das Anhaften von Schmutzpartikeln am porösen Körper verringert, so dass eine Beeinträchtigung des Gasvolumenstroms durch ein Verstopfen von Poren vermieden oder zumindest reduziert werden kann. Als Material für die hydrophobe Oberfläche kann beispielsweise Polytetrafluorethylen verwendet werden. Zusätzlich oder alternativ kann die hydrophobe Oberfläche auch Fette und/oder Wachse enthalten. Die Porosität und/oder die Porengröße der Poren des porösen Körpers kann im Bereich der hydrophoben Oberfläche kleiner sein als außerhalb des Bereichs mit der hydrophoben Oberfläche.

Bei einem bevorzugten Ausführungsbeispiel ist der poröse Körper durch ein Wirrfaserstrukturteil gebildet. Der poröse Körper weist miteinander verschlungene, ungeordnet angeordnete Fasern auf, die das Wirrfaserstrukturteil bilden. Vorzugsweise haben die Fasern einen Durchmesser von mindestens 70 Mikrometern und maximal 130 Mikrometern. Bevorzugt können alle Fasern oder zumindest ein Teil der Fasern des porösen Körpers mit der hydrophoben Oberfläche versehen sein. Es ist dabei möglich, die Fasern vor dem Verschlingen und somit vor Bildung des Wirrfaserstrukturteiles mit der hydrophoben Oberfläche zu versehen. Alternativ hierzu können die Fasern oder zumindest ein Teil der Fasern nach der Bildung des Wirrfaserstrukturteiles mit der hydrophoben Oberfläche versehen werden.

Es ist vorteilhaft, wenn die Porengröße des porösen Körpers mindestens 80 Mikrometer und maximal 250 Mikrometer beträgt. Die Porosität des porösen Körpers kann mindestens 60% und maximal 80% betragen. Diese Porengröße und/oder diese Porosität stellt einen hohen Gasvolumendurchsatz sicher und bewirkt gleichzeitig eine ausreichende mechanische Stabilität des porösen Körpers. Zwischen der Innenseite und der Außenseite kann der poröse Körper eine Dicke von mindestens 5 bis 10 mm aufweisen.

Der poröse Körper und vorzugsweise die Fasern des porösen Körpers sind aus einem temperaturfesten Werkstoff hergestellt. Der Werkstoff ist bis zu mindestens 400°C temperaturbeständig. Hierzu ist der poröse Körper bzw. sind die Fasern des porösen Körpers aus einem legierten Stahl, insbesondere aus einem chromlegierten Stahl, beispielsweise Edelstahl hergestellt sein.

Bei einem bevorzugten Ausführungsbeispiel sitzt der poröse Körper in einen Durchgang unmittelbar in der Gehäusewand oder in einem Gehäusewandabschnitt des Gehäuses. Alternativ hierzu kann auch ein Gehäusewandabschnitt, eine Gehäusewand oder auch alle Gehäusewände eines Gehäuses von einem porösen Körper gebildet sein.

Bei einem anderen Ausführungsbeispiel kann der poröse Körper in einem Durchgang eines Stutzens eingesetzt sein. Der Stutzen kann Bestandteil einer Druckentlastungsvorrichtung oder eines Klimastutzens sein.

Der poröse Körper kann kraftschlüssig, beispielsweise durch eine Übermaßpassung und/oder stoffschlüssig mit der den Durchgang begrenzenden Wand des Gehäuseteils verbunden sein. Es ist beispielsweise auch möglich, den porösen Körper in eine Gehäusewand oder einen Gehäusewandabschnitt einzuformen, beispielsweise indem der poröse Körper in einer Gussform eingelegt und mit dem Material der Gehäusewand bzw. des Gehäusewandabschnitts des Stutzens umspritzt oder umgossen wird.

Um das Eindringen von Spritzwasser, das mit hoher Geschwindigkeit auf den porösen Körper auftrifft, in den Innenraum des Gehäuses zu vermeiden, kann im Bereich der Außenseite des porösen Körpers im Gehäuseteil ein Spritzwasserschutz, vorzugsweise eine Spritzwasserschutzabdeckung vorhanden sein. Dadurch kann der poröse Körper vor mit hohem Druck auf das Gehäuseteil gerichtetem Spritzwasser geschützt werden.

Vorteilhafte Ausgestaltungen der Erfindung ergeben sich aus den abhängigen Patentansprüchen sowie der Beschreibung. Die Beschreibung beschränkt sich auf wesentliche Merkmale der Erfindung. Die Zeichnung ist ergänzend heranzuziehen. Nachfolgend werden bevorzugte Ausführungsbeispiele der Erfindung anhand der beigefügten Zeichnung im Einzelnen erläutert. Es zeigen:

Figur 1 eine perspektivische schematische Darstellung eines ersten Ausführungsbeispiels eines explosionsgeschützten Gehäuses,

Figur 2 eine perspektivische schematische Darstellung eines zweiten Ausführungsbeispiels eines explosionsgeschützten Gehäuses,

Figur 3 einen schematischen Querschnitt eines Ausführungsbeispiels einer Druckentlastungsvorrichtung für ein explosionsgeschütztes Gehäuse,

Figur 4 einen schematischen Querschnitt eines weiteren Ausführungsbeispiels einer Druckentlastungsvorrichtung,

Figuren 5 bis 7 jeweils ein Ausführungsbeispiel eines porösen Körpers in schematischer perspektivischer Ansicht,

Figur 8 einen schematischen Querschnitt eines porösen Körpers gemäß der Figuren 5 bis 7 in einer Prinzipdarstellung und

Figur 9 eine schematische Veranschaulichung der Funktionsweise der hydrophoben Oberfläche des porösen Körpers gemäß einem der Ausführungsbeispiele.

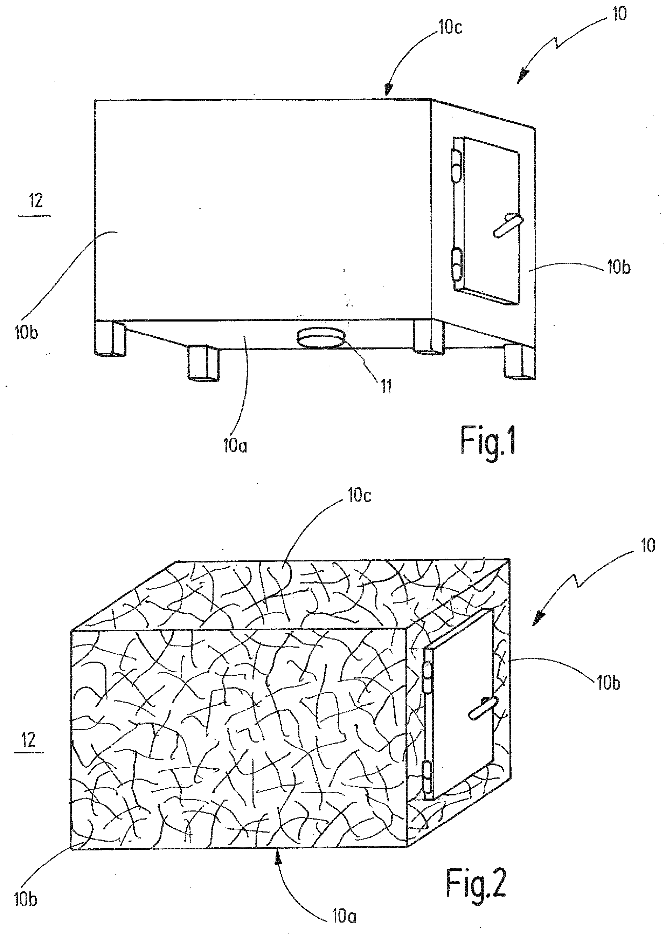

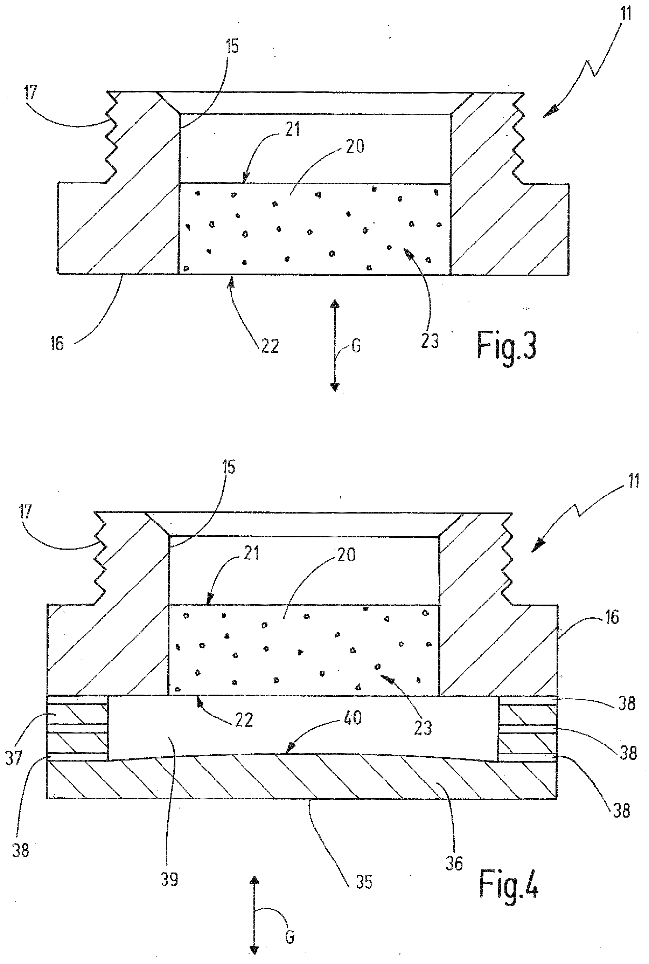

In Figur 1 ist lediglich schematisch ein Ausführungsbeispiel eines explosionsgeschützten Gehäuses 10 veranschaulicht. Das explosionsgeschützte Gehäuse 10 ist insbesondere in der Zündschutzart "druckfeste Kapselung" (Ex-d) ausgeführt. Es weist eine Durchströmvorrichtung 11 auf, die einen Gehäuseboden 10a, einen Gehäusewand 10b oder eine Gehäusedecke 10c des Gehäuses 10 durchsetzt. Ausführungsbeispiele für die Durchströmvorrichtung 11 sind in den Figuren 3 und 4 veranschaulicht.

Die Durchströmvorrichtung 11 kann als Druckentlastungsvorrichtung und/oder als Druckausgleichsvorrichtung dienen. In ihrer Funktion als Druckausgleichsvorrichtung werden Druckunterschiede zwischen dem Innenraum des Gehäuses 10 und der Umgebung 12 außerhalb des Gehäuses 10 ausgeglichen, in dem ein Gasvolumen durch die Durchströmvorrichtung 11 vom Innenraum in die Umgebung 12 oder umgekehrt strömen kann. Solche Druckunterschiede können sich beispielsweise aufgrund von Temperaturschwankungen ergeben, insbesondere wenn die Sonneneinstrahlung auf das explosionsgeschützte Gehäuse 10 einwirkt.

Das explosionsgeschützte Gehäuse muss in der Zündschutzart "druckfeste Kapselung" einem Explosionsdruck im Inneren des Gehäuses 10 standhalten können. Die Durchströmvorrichtung 11 kann dabei als Druckentlastungsvorrichtung dienen und den Explosionsdruck im Innenraum des Gehäuses 10 begrenzen. Hierfür ist ein ausreichend großer Volumenstrom durch die Durchströmvorrichtung 11 sichergestellt, wenn der Druck im Inneren des Gehäuses 10 bei einer Explosion ansteigt. Durch die Druckbegrenzung mittels der Durchströmvorrichtung 11 muss das Gehäuse 10 bei den zu erwartenden Explosionsdrücken weniger stabil ausgeführt sein, wodurch Material, Kosten und Gewicht eingespart werden können.

Die Durchströmvorrichtung 11 weist einen Durchgang 15 auf, der den Innenraum des Gehäuses 10 mit der Umgebung 12 verbindet und eine Gasströmung ermöglicht. Der Durchgang 15 kann in seinem Querschnitt beliebig konturiert sein. Bei den hier veranschaulichten Ausführungsbeispielen hat der Durchgang 15 einen kreisförmigen Querschnitt.

Der Durchgang 15 durchsetzt beispielsgemäß einen Stutzen 16. Der Stutzen 16 kann in einer Öffnung des Gehäuses 10 im Gehäuseboden 10a, in einer Gehäusewand 10b oder in der Gehäusedecke 10c befestigt werden. Beim Ausführungsbeispiel ist am Stutzen 16 ein Außengewinde 17 vorhanden, mittels dem der Stutzen 16 in ein Innengewinde in der Öffnung des betreffenden Gehäuseteils eingeschraubt werden kann. Der Stutzen 16 kann auch auf andere beliebige Art kraftschlüssig und/oder formschlüssig und/oder stoffschlüssig in der Öffnung des Gehäuses 10 angeordnet und fixiert sein.

In dem Gehäuse 10 sind elektrische und/oder elektronische Komponenten angeordnet, die nicht dargestellt sind. Solche Komponenten können als Zündquellen für eine explosionsgefährdete Atmosphäre in der Umgebung 12 des Gehäuses 10 dienen. Der Durchgang 15 der Durchströmvorrichtung 11 darf somit keinen Zündspalt aufweisen. Daher ist in den Durchgang 15 ein poröser Körper 20 eingesetzt. Der poröse Körper 20 erlaubt aufgrund seiner Porosität eine Gasströmung durch den porösen Körper 20 hindurch, stellt jedoch gleichzeitig sicher, dass Flammen oder Zündfunken nicht durch den Durchgang 15 aus dem Innenraum des Gehäuses 10 in die Umgebung 12 gelangen können.

Der poröse Körper 20 kann im Durchgang 15 stoffschlüssig und/oder kraftschlüssig und/oder formschlüssig befestigt sein. Beispielsweise ist es vorteilhaft, wenn der poröse Körper 20 bei der Herstellung des Stutzens 16 in eine Gussform eingelegt wird und unmittelbar durch die Herstellung des Stutzens 16 beim Einfüllen von Material in die Gussform eine stoffschlüssige Verbindung mit dem Stutzen 16 herstellt. Alternativ hierzu kann der poröse Körper 20 auch durch eine Übermaßpassung in dem Durchgang 15 gehalten werden, wobei zwischen der den Durchgang 15 begrenzenden Wand des Stutzens 16 und dem porösen Körper 20 eine elastische Klemmkraft erzeugt wird. Bei dieser Ausführung kann der poröse Körper 20 zusätzlich durch Sicherungsmittel in Erstreckungsrichtung des Durchgangs 15 gegen ein Verschieben bzw. Herausdrücken aus dem Durchgang 15 gesichert werden.

Der poröse Körper 20 hat beim Ausführungsbeispiel die Form einer Scheibe. Er weist eine dem Innenraum des Gehäuses 10 zugeordnete Innenseite 21 und eine der Umgebung 12 außerhalb des Gehäuses 10 zugeordnete Außenseite 22 auf. Gas kann beispielsweise an der Innenseite 21 in den porösen Körper 20 eintreten und an der Außenseite 22 austreten oder auch umgekehrt. Die Innenseite 21 und die Außenseite 22 sind über eine Umfangsfläche 23 miteinander verbunden. Die Umfangsfläche 23 ist ringförmig geschlossen. In Draufsicht auf die Innenseite 21 oder die Außenseite 22 hat der poröse Körper 20 eine Kontur oder Form, die an die Kontur oder Form der Querschnittsfläche des Durchgangs 15 derart angepasst ist, dass eine zündspaltfreie Verbindung zwischen den porösen Körper 20 und der den Durchgang 15 begrenzenden Wandung möglich ist. Beim Ausführungsbeispiel hat der poröse Körper 20 eine kreisrunde Kontur.

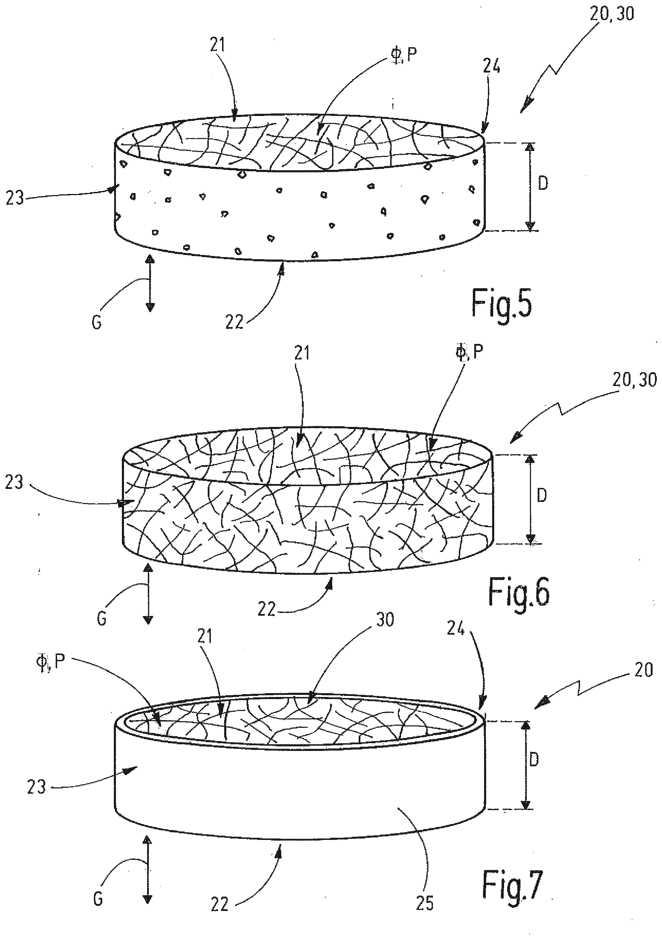

Vorzugsweise weist der poröse Körper Fasern 29 auf, die ungeordnet miteinander verschlungen sind. Der poröse Körper 20 weist somit ein Wirrfaserstrukturteil auf (Figur 7) oder ist von einem solchen Wirrfaserstrukturteil 30 gebildet.

Die Fasern bestehen vorzugsweise aus Metall und beim Ausführungsbeispiel aus einem chrom-legierten Stahl bzw. Edelstahl. Die Fasern 29 haben vorzugsweise alle denselben Durchmesser. Der Durchmesser beträgt mindestens 70 Mikrometer und maximal 130 Mikrometer.

Die Porosität $\Phi$ des porösen Körpers 20 kann wie folgt berechnet werden:

$$\Phi = (1 - \frac{\rho}{\rho_0}) \cdot 100\% \ ,$$

mit

    $\Phi$: Porosität in Prozent
    $\rho$: Rohdichte des Körpers
    $\rho_0$: Reindichte des Körpers

Bei dem in Figur 6 veranschaulichten Ausführungsbeispiel des porösen Körpers 20 ist die Porosität $\Phi$ im Wesentlichen über den gesamten porösen Körper 20 konstant. Im Unterschied dazu ist bei den Ausführungsbeispielen gemäß Figur 5 und 6 die Porosität $\Phi$ in einem die Umfangsfläche 23 aufweisenden Randbereich 24 kleiner. Bei der in Figur 7 dargestellten Ausführungsform weist der poröse Körper 20 zusätzlich zu seinem porösen Material ein Ringteil 25 auf, das das poröse Material bzw. das Wirrfaserstrukturteil 30 ringförmig umschließt und somit eine im Wesentlichen gasdicht geschlossene Umfangsfläche 23 des porösen Körpers 20 bildet. Lediglich an der Innenseite 21 bzw. der Außenseite 22 ist ein Gaseintritt bzw. ein Gasaustritt möglich.

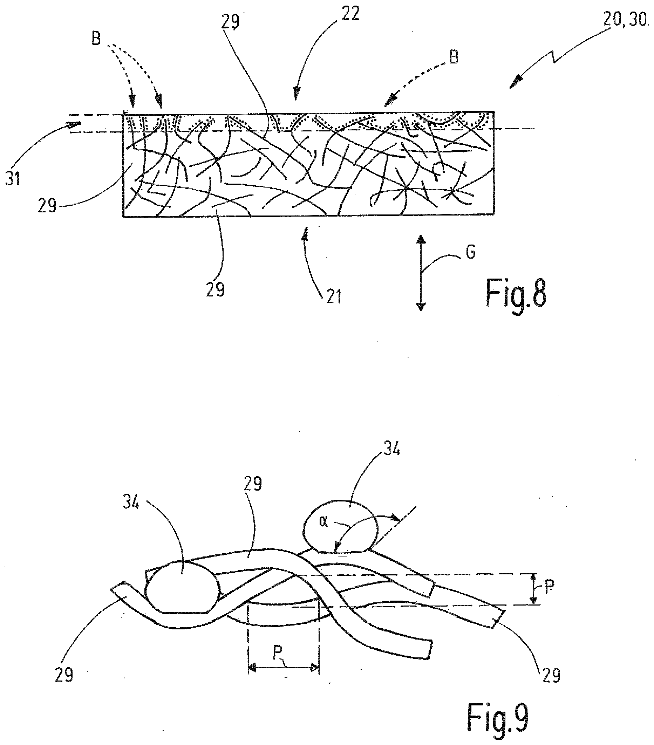

Die Porosität $\Phi$ des porösen Körpers 20 bzw. des Wirrfaserstrukturteils 30 beträgt mindestens 60% und maximal 80%. Die Porengröße P des porösen Körpers 20 bzw. des Wirrfaserstrukturteils 30 liegt zumindest in einer Raumrichtung und vorzugsweise in zumindest zwei Raumrichtungen in einem Bereich von mindestens 80 Mikrometern bis maximal 250 Mikrometern. Insbesondere liegt die Porengröße P in den beiden Raumrichtungen im angegebenen Bereich, in denen sich die Innenseite 21 und die Außenseite 22 quer zur Gasströmungsrichtung G erstrecken. Die Porengröße P ist schematisch in Figur 9 veranschaulicht.

Die Dicke D des porösen Körpers 20 zwischen der Innenseite 21 und der Außenseite 22 beträgt mindestens 5 bis 10 mm.

Der poröse Körper 20 bzw. das Wirrfaserstrukturteil 30 weist eine hydrophobe Oberfläche B auf. Diese hydrophobe Oberfläche B ist in Figur 8 sehr stark schematisiert veranschaulicht und dort beispielsgemäß durch eine Beschichtung gebildet. Alternativ hierzu kann die hydrophobe Oberfläche auch durch Aktivierung und/oder Behandlung des Werkstoffes des porösen Körpers 20 bzw. des Wirrfaserstrukturteils 30 erzeugt werden. Zum Beispiel ist eine Aktivierung der hydrophoben Eigenschaften durch eine Laserinterferenzstrukturierung oder Erzeugung von Nanostrukturen möglich.

Die hydrophobe Oberfläche B ist unmittelbar am Wirrfaserstrukturteil 30 bzw. dem porösen Körper 20 angebracht. Beim Ausführungsbeispiel sind die Fasern 29 zumindest in einem Bereich 31 des porösen Körpers 20 bzw. des Wirrfaserstrukturteils 30 mit der hydrophoben Oberfläche B versehen. Dieser Bereich 31 enthält beispielsgemäß zumindest die Außenseite 22. Alternativ oder zusätzlich könnte der Bereich 31 auch die Innenseite 21 enthalten und sich daran anschließen. Es ist weiterhin auch möglich, mehrere Bereiche 31 oder den gesamten porösen Körper 20 bzw. das gesamte Wirrfaserstrukturteil 30 mit einer hydrophoben Oberfläche B zu versehen. Beispielsweise können die Fasern 29 vor der Verschlingung zum Wirrfaserstrukturteil 30 mit der hydrophoben Oberfläche B versehen sein. Vorzugsweise wird die hydrophobe Oberfläche B aber erst in dem zumindest einen Bereich 31 als Beschichtung auf den porösen Körper 20 bzw. das Wirrfaserstrukturteil 30 aufgebracht oder an dem porösen Körper 20 bzw. das Wirrfaserstrukturteil 30 erzeugt.

Wie in Figur 8 veranschaulicht, wird vorzugsweise zumindest eine die Außenseite 22 enthaltende und sich an diese Außenseite 22 anschließende Schicht des Wirrfaserstrukturteils 30 bzw. des porösen Körpers 20 mit der hydrophoben Oberfläche B versehen. Dies hat den Vorteil, dass im Falle einer Explosion im Innenraum des Gehäuses 10 die Heißgasse, die an der Innenseite 21 eintreten, zunächst abgekühlt werden, bis sie den Bereich 31 mit der hydrophoben Oberfläche B erreichen. Die hydrophobe Oberfläche B bzw. Beschichtung kann daher auch weniger temperaturbeständig sein als das zur Herstellung des porösen Körpers 20 verwendete Material.

Vorzugsweise weist das zur Herstellung des porösen Körpers 20 bzw. des Wirrfaserstrukturteils 30 verwendete Material, beispielsgemäß die Fasern 29, eine Temperaturbeständigkeit von zumindest 400°C auf. Der beispielsgemäß für die durch eine Beschichtung gebildete hydrophobe Oberfläche B verwendete Werkstoff enthält beim Ausführungsbeispiel ein Fluorcarbon. Beispielsweise kann die Oberfläche B Polytetrafluorethylen enthalten oder daraus gebildet sein. Auch andere Werkstoffe mit einem Fluorcarbon und/oder einem oder mehreren Silanen sind verwendbar. Die Fluorcarbone und/oder Silane haben den Vorteil, dass sie nicht nur das Eindringen von Wasser durch den porösen Körper 20 in den Innenraum des Gehäuses 10 verhindern, sondern auch das Eindringen von öligen Fluiden erschweren oder behindern. Ferner erschweren Fluorcarbone das Anhaften von Partikeln am porösen Körper 20, so dass die Poren sich nicht mit Schmutzpartikeln zusetzen und den Gasvolumenstrom durch den porösen Körper 20 erschweren bzw. verringern.

Alternativ oder zusätzlich zu einem Fluorcarbon und/oder einem Silan kann der Werkstoff der hydrophoben Oberfläche B auch ein Fett und/oder ein Wachs enthalten.

Die Porosität Φ bzw. die Porengröße P kann in dem Bereich 31 mit der hydrophoben Oberfläche B geringer sein als außerhalb dieses Bereichs 31. Vorzugsweise ist die Porosität Φ und/oder die Porengröße P dennoch innerhalb des jeweiligen oben angegebenen Bereichs, das heißt, die Porengröße P beträgt mindestens 80 Mikrometer und maximal 150 Mikrometer und/oder die Porosität Φ beträgt mindestens 60% und maximal 80%.

Durch die hydrophobe Oberfläche B wird der Kontaktwinkel α zwischen einem Wassertropfen 34 und der Oberfläche auf der Außenseite 22 des porösen Körpers 20 bzw. des Wirrfaserstrukturteils 30 vergrößert und ist größer als 90° und vorzugsweise größer als 120° und weiter vorzugsweise größer als 160°. Dadurch wird erreicht, dass sich kleinere Wassertropfen, die kleiner sind als die Porengröße P zu größeren Wassertropfen 34 verbinden und nicht durch die Poren hindurch in den Innenraum des Gehäuses 10 gelangen können. Der Bereich 31 mit der hydrophoben Oberfläche B wird somit nicht von Wassertropfen durchsetzt. Es ist dabei unerheblich, ob der Bereich 31 unmittelbar an der Außenseite 22 oder an einem anderen Abschnitt des porösen Körpers 20 bzw. des Wirrfaserstrukturteils 30 vorhanden ist.

Die Durchströmungsvorrichtung 11 weist bei dem Ausführungsbeispiel gemäß Figur 4 auf der der Umgebung 12 zugeordneten Seite eine Schutzabdeckung 35 auf. Die Schutzabdeckung 35 ist mit Abstand zur Außenseite 22 des porösen Körpers 20 angeordnet und beispielsgemäß mit dem Stutzen 16 verbunden. Die Schutzabdeckung 35 weist einen geschlossenen Schutzwandbereich 36 auf, der mit Abstand zur Außenseite 22 angeordnet ist und die Außenseite 22 vollständig abdeckt. Der Schutzwandabschnitt 36 ist durch wenigstens ein Halteelement 37 mit dem Stutzen 16 verbunden. Das wenigstens eine Halteelement 37 erstreckt sich vom Stutzen 16 weg und hält dadurch den Schutzwandabschnitt 36 auf Abstand zur Außenseite 22 des porösen Körpers 20 und mit Abstand zur Mündung des Durchgangs 15. Beim Ausführungsbeispiel ist ein einziges, ringförmig geschlossenes Halteelement 37 vorhanden, das auf der der Umgebung 12 zugeordneten Seite des Stutzens 16 die Ausmündung des Durchgangs 15 ringförmig umschließt. In Abwandlung hierzu könnten auch über den Umfang verteilt mehrere einzelne Halteelemente 37 vorgesehen sein.

Das beispielsgemäß ringförmig geschlossene Halteelement 37 weist in Umfangsrichtung verteilt mehrere Abflusskanäle 38 auf. Durch diese Abflusskanäle 38 kann Wasser, das sich in einem Zwischenraum 39 zwischen dem Schutzwandabschnitt 36 und dem porösen Körper 20 sammelt, aus dem Zwischenraum 39 heraus ablaufen. Durch den Schutzwandabschnitt 36 ist der poröse Körper 20 bzw. dessen Außenseite 22 davor geschützt, dass Spritzwasser bzw. ein Wasserstrahl direkt auf den porösen Körper 20 auftrifft. Die Schutzabdeckung 35 bildet somit einen Strahl- und Spritzwasserschutz.

Die dem Zwischenraum 39 zugewandte Innenfläche 40 des Schutzwandabschnitts 36 erstreckt sich bei dem hier dargestellten Ausführungsbeispiel nicht in einer Ebene, sondern hat eine konvexe Form. Dadurch wird eine Neigung gebildet, so dass Wasser, das sich im Zwischenraum 39 auf der Innenfläche 40 sammelt, in Richtung der Abflusskanäle 38 fliest. Dies ist dann vorteilhaft, wenn die Durchströmvorrichtung 11 an einem Gehäuseboden 10a angebracht wird, wie es in Figur 1 schematisch veranschaulicht ist.

Bei den Ausführungsbeispielen gemäß der Figuren 1, 2 und 3 ist der Durchgang 15 in einem Gehäuseteil angeordnet, das von dem Stutzen 16 gebildet ist. Alternativ hierzu ist es auch möglich, den Durchgang 15 unmittelbar in einer Gehäusewand 10b, einem Gehäuseboden 10a oder einem Gehäusedeckel 10c vorzusehen und den porösen Körper 20 unmittelbar dort anzuordnen. Der Stutzen 16 entfällt bei dieser Ausführungsform.

Es ist ferner möglich, ganze Gehäuseteile, beispielsweise Gehäusewände 10b, Gehäusedecken 10c oder Gehäuseböden 10b aus dem porösen Körper 20 auszuführen, was schematisch in Figur 2 veranschaulicht ist. Auch eine Gehäusetür oder ein Deckel könnten alternativ zu dieser Darstellung von einem porösen Körper 20 gebildet sein. Dabei ist eine Gaskommunikation zwischen dem Innenraum des Gehäuses 10 und der Umgebung 12 durch alle Gehäuseteile 10a, 10b, 10c möglich, die durch einen porösen Körper 20 gebildet sind.

Bei allen Ausführungsformen ist wenigstens ein Bereich 31 jedes porösen Körpers 20 mit der hydrophoben Oberfläche B versehen.

Die Erfindung betrifft ein Gehäuseteil für ein explosionsgeschütztes Gehäuse 10. Das Gehäuseteil kann von einem Stutzen 16 einer Durchströmungsvorrichtung 11 und/oder von einer Gehäusewand 10b und/oder von einem Gehäuseboden 10a und/oder von einer Gehäusedecke 10c gebildet sein. Dieses Gehäuseteil weist einen porösen Körper 20 auf, der in einem Durchgang 15 des Gehäuseteils sitzt. Der Durchgang 15 ist durch den porösen Körper 20 zünddurchschlagsicher verschlossen. Der poröse Körper 20 weist eine dem Innenraum des Gehäuses 10 zugeordnete Innenseite 21 und eine der Umgebung 12 mit der explosionsgefährdeten Atmosphäre zugeordnete Außenseite 22 auf. Durch den porösen Körper 20 kann ein Gasvolumenstrom strömen. Gas kann an der Innenseite 21 in den porösen Körper 20 eintreten und an der Außenseite 22 austreten oder umgekehrt. Um das Eindringen von Wasser bzw. anderen wässrigen Flüssigkeiten in den Innenraum des Gehäuses 10 zu vermeiden, weist der poröse Körper 20 in zumindest einem Bereich 31 eine hydrophobe Oberfläche B auf.

Bezugszeichenliste:

| 10 | Gehäuse |
| 10a | Gehäuseboden |
| 10b | Gehäusewand |
| 10c | Gehäusedecke |
| 11 | Durchströmvorrichtung |
| 12 | Umgebung |
| | |
| 15 | Durchgang |
| 16 | Stutzen |
| 17 | Außengewinde |
| | |
| 20 | poröser Körper |
| 21 | Innenseite |
| 22 | Außenseite |
| 23 | Umfangsfläche |
| 24 | Randbereich |
| 25 | Ringteil |
| | |
| 29 | Faser |
| 30 | Wirrfaserstrukturteil |
| 31 | Bereich |

| 34 | Wassertropfen |
| 35 | Schutzabdeckung |
| 36 | Schutzwandabschnitt |
| 37 | Halteelement |
| 38 | Abflusskanal |
| 39 | Zwischenraum |
| | |
| $\alpha$ | Kontaktwinkel |
| P | Porosität |
| D | Dicke |
| B | hydrophobe Oberfläche |
| G | Gasströmungsrichtung |
| P | Porengröße |

**Patentansprüche**

1. Gehäuseteil für ein explosionsgeschütztes Gehäuse (10),
mit einem Durchgang (15), in den ein zünddurchschlagsicherer poröser Körper (20), zur Bildung einer Druckentlastungsvorrichtung eingesetzt ist, um einen Explosionsdruck in einem Innenraum des Gehäuses (10) zu begrenzen,
wobei der poröse Körper (20) eine gasdurchlässige Verbindung zwischen einer dem Innenraum des Gehäuses (10) zugeordneten Innenseite (21) des porösen Körpers (20) und einer der Umgebung (12) des Gehäuses (10) zugeordneten Außenseite (22) des porösen Körpers (20) bereitstellt,
**dadurch gekennzeichnet, dass** der poröse Körper (20) aus einem legierten Stahl besteht, der bis zu mindestens 400°C temperaturbeständig ist und zur Bildung einer hydrophoben Oberfläche (B) eine hydrophobe Beschichtung aufweist .

2. Gehäuseteil nach Anspruch 1,
**dadurch gekennzeichnet, dass** die hydrophobe Oberfläche (B) nur in einem Bereich (31) des porösen Körpers vorhanden ist.

3. Gehäuseteil nach Anspruch 1 oder 2,
**dadurch gekennzeichnet, dass** die hydrophobe Oberfläche (B) wenigstens eine Schicht bildet, die die Außenseite (22) und/oder die Innenseite (21) des porösen Körpers (20) enthält und sich an die Außenseite (22) und/oder die Innenseite (21) des porösen Körpers (20) anschließt.

4. Gehäuseteil nach einem der vorhergehenden Ansprüche,
**dadurch gekennzeichnet, dass** die hydrophobe Beschichtung (B) ein Fluorcarbon und/oder ein Silan enthält.

5. Gehäuseteil nach einem der vorhergehenden Ansprüche,
**dadurch gekennzeichnet, dass** die hydrophobe Beschichtung (B) ein Fett und/oder ein Wachs enthält.

6. Gehäuseteil nach einem der vorhergehenden Ansprüche,
   **dadurch gekennzeichnet, dass** der poröse Körper (20) aus Fasern (29) gebildet ist oder Fasern aufweist, die einen Durchmesser von mindestens 70 Mikrometern und maximal 130 Mikrometern aufweisen.

7. Gehäuseteil nach Anspruch 6,
   **dadurch gekennzeichnet, dass** die Fasern (29) des porösen Körpers (20) mit der hydrophoben Beschichtung (B) versehen sind.

8. Gehäuseteil nach einem der vorhergehenden Ansprüche,
   **dadurch gekennzeichnet, dass** die Porengröße (P) des porösen Körpers (20) mindestens 80 Mikrometer und maximal 250 Mikrometer beträgt.

9. Gehäuseteil nach einem der vorhergehenden Ansprüche,
   **dadurch gekennzeichnet, dass** die Porosität (Φ) des porösen Körpers (20) mindestens 60% und maximal 80% beträgt.

10. Gehäuseteil nach einem der vorhergehenden Ansprüche,
    **dadurch gekennzeichnet, dass** es von einem Stutzen (16) gebildet ist, in dessen Durchgang (15) der poröse Körper (20) eingesetzt ist.

11. Gehäuseteil nach Anspruch 10,
    **dadurch gekennzeichnet, dass** der Stutzen (16) auf der Seite, die der Außenseite (22) des porösen Körpers (20) zugeordnet ist, einen Spritzwasserschutz (35) aufweist.

12. Gehäuseteil nach einem der vorhergehenden Ansprüche,
    **dadurch gekennzeichnet, dass** der poröse Körper zünddurchschlagsicher ausgeführt ist.

13. Druckfest gekapseltes Gehäuse (10) mit einem Gehäuseteil (16) nach einem der vorhergehenden Ansprüche.

**Claims**

1. Housing part for an explosion-protected housing (10),
   with a passage (15) in which a flameproof porous body (20) is inserted to form a pressure-relief device in order to limit an explosion pressure in an interior of the housing (10),

wherein the porous body (20) provides a gas-permeable connection between an inside (21) of the porous body (20) assigned to the interior of the housing (20), and an outside (22) of the porous body assigned to the environment (12) of the housing (20), **characterised in that** the porous body (20) consists of an alloyed steel which is temperature-resistant up to at least 400°C and has a hydrophobic coating to form a hydrophobic surface (B).

2. Housing part according to claim 1, **characterised in that** the hydrophobic surface (B) is present only in one region (31) of the porous body.

3. Housing part according to claim 1 or 2, **characterised in that** the hydrophobic surface (B) forms at least one layer which contains the outside (22) and/or the inside (21) of the porous body (20) and adjoins the outside (22) and/or the inside (21) of the porous body (20).

4. Housing part according to any of the preceding claims, **characterised in that** the hydrophobic coating (B) contains a fluorocarbon and/or a silane.

5. Housing part according to any of the preceding claims, **characterised in that** the hydrophobic coating (B) contains a grease and/or a wax.

6. Housing part according to any of the preceding claims, **characterised in that** the porous body (20) is formed of fibres or comprises fibres which have a diameter of at least 70 microns and at most 130 microns.

7. Housing part according to claim 6, **characterised in that** the fibres (29) of the porous body (20) are provided with the hydrophobic coating (B).

8. Housing part according to any of the preceding claims, **characterised in that** the pore size (P) of the porous body (20) is at least 80 microns and at most 250 microns.

9. Housing part according to any of the preceding claims, **characterised in that** the porosity (Φ) of the porous body (20) is at least 60% and at most 80%.

10. Housing part according to any of the preceding claims, **characterised in that** it is formed by a connector (16), in the passage (15) of which the porous body (20) is inserted.

11. Housing part according to claim 10, **characterised in that** the connector (16) has a splash-water protection (35) on the side assigned to the outside (22) of the porous body (20).

**12.** Housing part according to any of the preceding claims, **characterised in that** the porous body is configured so as to be flameproof.

**13.** Pressure-resistant, encapsulated housing (10) with a housing part (16) according to any of the preceding claims.

**Revendications**

**1.** Partie de boîtier pour un boîtier antidéflagrant (10), comprenant un passage (15) dans lequel est inséré un corps poreux (20) résistant au claquage, en vue de former un dispositif de décharge de pression, afin de limiter une pression d'explosion dans un espace interne du boîtier (10),
sachant que le corps poreux (20) fournit une liaison perméable au gaz entre une face intérieure (21) du corps poreux (20), associée à l'espace interne du boîtier (10), et une face extérieure (22) du corps poreux (20), associée à l'environnement (12) du boîtier (10),
**caractérisée en ce que** le corps poreux (20) se compose d'un acier allié qui résiste aux températures, au moins jusqu'à 400 °C, et pré-sente un revêtement hydrophobe en vue de la formation d'une surface hydrophobe (B).

**2.** Partie de boîtier selon la revendication 1, **caractérisée en ce que** la surface hydrophobe (B) n'est présente que dans une zone (31) du corps poreux.

**3.** Partie de boîtier selon la revendication 1 ou 2, **caractérisée en ce que** la surface hydrophobe (B) forme au moins une couche qui comporte la face extérieure (22) et/ou la face intérieure (21) du corps poreux (20) et se raccorde à la face extérieure (22) et/ou à la face intérieure (21) du corps poreux (20).

**4.** Partie de boîtier selon l'une des revendications précédentes, **caractérisée en ce que** le revêtement hydrophobe (B) contient un fluorocarbone et/ou un silane.

**5.** Partie de boîtier selon l'une des revendications précédentes, **caractérisée en ce que** le revêtement hydrophobe (B) contient une graisse et/ou une cire.

**6.** Partie de boîtier selon l'une des revendications précédentes, **caractérisée en ce que** le corps poreux (20) est constitué de fibres (29) ou présente des fibres qui ont un diamètre d'au moins 70 micromètres et d'au maximum 130 micromètres.

**7.** Partie de boîtier selon la revendication 6, **caractérisée en ce que** les fibres (29) du corps poreux (20) sont pourvues du revêtement hydrophobe (B).

**8.** Partie de boîtier selon l'une des revendications précédentes, **caractérisée en ce que** la grosseur de pore (P) du corps poreux (20) est au moins de 80 micromètres et au maximum de 250 micromètres.

**9.** Partie de boîtier selon l'une des revendications précédentes, **caractérisée en ce que** la porosité ($\phi$) du corps poreux (20) est au moins de 60 % et au maximum de 80 %.

**10.** Partie de boîtier selon l'une des revendications précédentes, **caractérisée en ce qu'**elle est constituée d'un raccord (16) dans le passage (15) duquel est inséré le corps poreux (20).

**11.** Partie de boîtier selon la revendication 10, **caractérisée en ce que**, sur le côté qui est associé à la face extérieure (22) du corps poreux (20), le raccord (16) présente une protection contre les projections d'eau (35).

**12.** Partie de boîtier selon l'une des revendications précédentes, **caractérisée en ce que** le corps poreux est réalisé de manière à résister au claquage.

**13.** Boîtier (10) à enveloppe antidéflagrante, comprenant une partie de boîtier (16) selon l'une des revendications précédentes.

Fig.1

Fig.2

Fig.3

Fig.4

Fig.5

Fig.6

Fig.7

Fig.8

Fig.9

**IN DER BESCHREIBUNG AUFGEFÜHRTE DOKUMENTE**

**In der Beschreibung aufgeführte Patentdokumente**

- US 4180177 A
- DE 102010016782 A1
- EP 2404652 A1
- DE 4313776 C1
- DE 102008024844 A1
- US 3987258 A